# EUROPEAN PATENT SPECIFICATION

(11) **EP 3 200 315 B1**
(45) Date of publication and mention of the grant of the patent: **27.05.2020**
(21) Application number: 15844196.4
(22) Date of filing: 16.09.2015
(51) Int. Cl.: H02J 13/00, H02J 3/00, G01R 22/06, G01D 4/00, G01R 21/00, H02J 3/32, H02J 3/38, H02J 3/14

(54) **POWER MANAGEMENT DEVICE, POWER MANAGEMENT METHOD, AND POWER MANAGEMENT SYSTEM**
LEISTUNGSVERWALTUNGSVORRICHTUNG, LEISTUNGSVERWALTUNGSVERFAHREN UND LEISTUNGSVERWALTUNGSSYSTEM
DISPOSITIF, PROCÉDÉ ET SYSTÈME DE GESTION DE PUISSANCE

(30) Priority: 26.09.2014 JP 2014197612
(43) Date of publication of application: 02.08.2017
(73) Proprietor: Kyocera Corporation, Kyoto-shi Kyoto 612-8501 (JP)
(72) Inventor: SHINOZAKI, Takayuki, Kyoto-shi Kyoto 612-8501 (JP)
(74) Representative: SSM Sandmair
(86) International application number: PCT/JP2015/076222
(87) International publication number: WO 2016/047511

(56) References cited:
- WO-A2-2010/065197
- JP-A- 2014 021 616
- JP-A- 2014 153 337
- JP-A- 2014 153 337
- US-A1- 2010 274 405

## Description

### TECHNICAL FIELD

The present invention relates to a power management apparatus, a power management method, and a power management system, that manages power information indicating power supplied to a consumer's facility from a power grid.

### BACKGROUND ART

In recent years, attention is drawn to a power management system (EMS: Energy Management System) that controls power of equipment provided in a consumer's facility. In such a power management system, a power management apparatus that manages the power of the equipment is provided.

The power management apparatus may include HEMS (Home Energy Management System) provided in a house, BEMS (Building Energy Management System) provided in a building, FEMS (Factory Energy Management System) provided in a factory, and SEMS (Store Energy Management System) provided in a shop (for example, Patent Document 1).

In such a case, as a meter that measures the power supplied to the consumer's facility from the power grid, the introduction of a smart meter having a communication function has been studied. The smart meter has a function of transmitting, to the power management apparatus, an accumulated value that is a value obtained by aggregating the power supplied to the consumer's facility from the power grid within each certain period.

### PRIOR ART

Patent Document 1: WO 2011/058761.

Relevant background art is reflected by JP 2014 153337. Further background art is reflected by WO 2010/065197 and US 2010/274405.

### SUMMARY OF THE INVENTION

In such a case, it is required to improve the convenience of the power management apparatus, the power management method, and a power management system.

The present invention has been made to provide the power management apparatus, the power management method, and a power management system, which can improve the convenience of the consumer's facility.

A power management apparatus according to a first aspect of the invention comprises the features of claim 1.

A power management method according to a second aspect of the invention comprises the features of claim 11.

A power management system according to a third aspect of the invention comprises the features of claim 12.

### BRIEF DESCRIPTION OF THE DRAWINGS

Fig. 1 is a diagram illustrating a consumer's facility 10 according to a first embodiment.
Fig. 2 is a drawing illustrating a smart meter 300 according to the first embodiment.
Fig. 3 is a diagram illustrating an EMS 200 according to the first embodiment.
Fig. 4 is a diagram illustrating information displayed by the EMS 200 according to the first embodiment.
Fig. 5 is a diagram illustrating information displayed by the EMS 200 according to the first embodiment.
Fig. 6 is a diagram illustrating a management method according to the first embodiment.
Fig. 7 is a diagram illustrating a management method according to the first embodiment.
Fig. 8 is a diagram for describing a correction according to a first modification.
Fig. 9 is a diagram for describing the correction according to the first modification.
Fig. 10 is a diagram for describing display of complementary information according to a second modification.

### DESCRIPTION OF THE EMBODIMENT

A power management apparatus according to an embodiment of the present invention will be described with reference to the drawings, below. It is noted that, in the following description of the drawings, identical or like numerals and symbols are assigned to identical or like parts.

It is appreciated that the drawings are schematically shown and the ratio and the like of each dimension are different from the real ones. Accordingly, specific dimensions and the like should be finalized in consideration of the explanation below. Further, it is needless to say that, among the drawings, the dimensional relationship and the ratio may be different.

### [Overview of Embodiment]

A power management apparatus according to embodiments comprises the features of any one of claims 1 to 10.

A power management method according to embodiments comprises the features of claim 11.

A power management system according to embodiments comprises the features of claim 12.

In the embodiment, it should be noted that it dare to provide the power sensor that measures the power as same way as the smart meter, even though it is sufficient to provide the smart meter by all rights.

### [First Embodiment]

### (Consumer's facility)

The consumer's facility according to the first embodiment will be described, below.

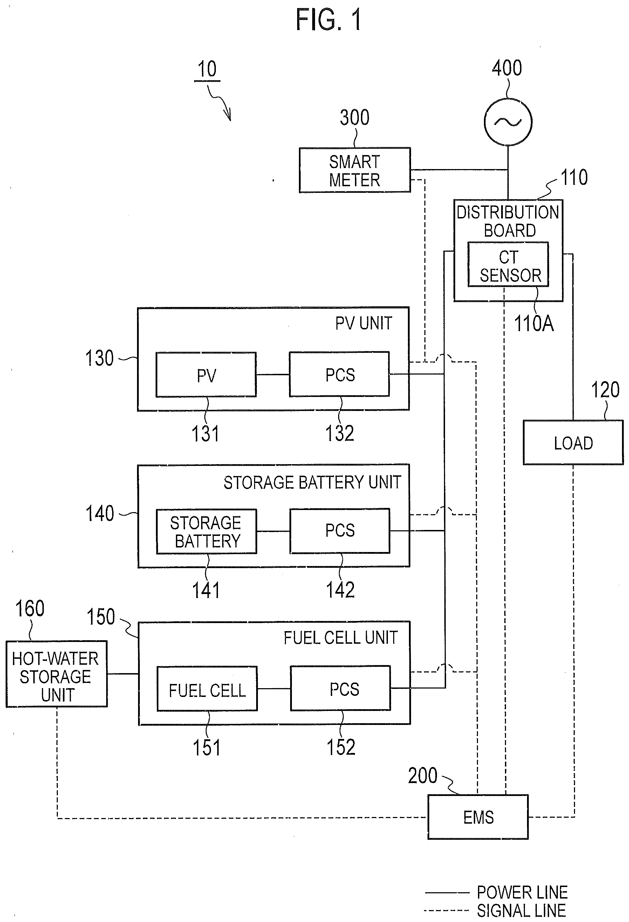

As illustrated in Fig. 1, the consumer's facility 10 includes a distribution board 110, a load 120, a PV unit 130, a storage battery unit 140, a fuel cell unit 150, and a hot-water storage unit 160. The consumer's facility 10 includes, in addition thereto, an EMS 200, and a smart meter 300. However, it should be noted that it is not necessary that the smart meter 300 and the EMS 200 are provided in the building of the consumer's facility 10.

The distribution board 110 is connected to the power grid 400. The distribution board 110 is connected, via a power line, to the load 120, the PV unit 130, the storage battery unit 140, and the fuel cell unit 150.

In the first embodiment, the distribution board 110 includes a CT (Current Transformer) sensor 110A that measures the power supplied to the consumer's facility 10 from the power grid 400. The CT sensor 110A is provided separately from the smart meter 300 that performs charging for the power supplied to the consumer's facility 10 from the power grid 400. The CT sensor 110A is an example of a power sensor that measures the power supplied to the consumer's facility 10 from the power grid. Here, a value of the power measured by the CT sensor 110A (i.e., a measured value) may be an accumulated value of the power supplied to the consumer's facility 10 in a unit of time, and may be an instantaneous value of the power supplied to the consumer's facility 10.

The load 120 is a device that consumes the power supplied via a power line. Examples of the load 120 include an equipment such as a refrigerator, a lighting, an air conditioner, and TV. The load 120 may be a singular equipment, and may include a plurality of equipments.

The PV unit 130 includes a PV 131 and a PCS 132. The PV 131 is an equipment that generates power in response to reception of solar light. The PV 131 outputs the generated DC power. An amount of power to be generated by the PV 131 varies depending on the solar radiation entering the PV 131. The PCS 132 is an equipment (Power Conditioning System) which converts the DC power output from the PV 131, into AC power. The PCS 132 outputs the AC power to the distribution board 110 through a power line. The PV unit 130 may include a pyranometer which measures the solar radiation entering the PV 131.

The PV unit 130 is controlled by an MPPT (Maximum Power Point Tracking) method. In particular, the PV unit 130 optimizes an operation point (point finalized by an operation-point voltage value and a power value, or a point finalized by an operation-point voltage value and a current value) of the PV 131.

The storage battery unit 140 has a storage battery 141 and a PCS 142. The storage battery 141 is an equipment in which power is accumulated. The PCS 142 is an equipment (Power Conditioning System) which converts the DC power output from the storage battery 141 into the AC power.

The fuel cell unit 150 has a fuel cell 151 and a PCS 152. The fuel cell 151 is an equipment which utilizes the fuel gas to generate power. The PCS 152 is an equipment (Power Conditioning System) which converts the DC power output from the fuel cell 151, into AC power. The PCS 152 may be a multi-PCS integrated with at least one function of the PCS 132 of the PV unit 130 and the PCS 142 of the storage battery unit 140.

The fuel cell unit 150 is operated by load following control. In particular, the fuel cell unit 150 controls the fuel cell 151 so that the power output from the fuel cell 151 follows the power consumed by the load 120, for example.

The hot-water storage unit 160 converts the power into heat and stores the heat. Specifically, the hot-water storage unit 160 has a hot-water storage tank where the water supplied from the hot-water storage tank is warmed by the heat exhausted by operating (power generation by) the fuel cell 151. In particular, the hot-water storage unit 160 warms the water supplied from the hot-water storage tank and feeds the warmed water back to the hot-water storage tank.

The EMS 200 is an example of a power management apparatus that manages power information indicating the power supplied to the consumer's facility 10 from the power grid 400.

Specifically, the EMS 200 is connected, via a signal line, to the load 120, the PV unit 130, the storage battery unit 140, the fuel cell unit 150, and the hot-water storage unit 160, and controls the load 120, the PV unit 130, the storage battery unit 140, the fuel cell unit 150, and the hot-water storage unit 160. The EMS 200 may control an operation mode of the load 120 to control the power consumption of the load 120. The signal line for connecting the EMS 200 and the equipment may be wireless or wired. It is noted that, in the following description, the PV unit 130, the storage battery units 140, and the fuel cell unit 150 may be referred collectively to as a distributed power source.

In the first embodiment, the EMS 200 is connected via a signal line to the CT sensor 110A and the smart meter 300 to perform communication with the CT sensor 110A and the smart meter 300. The signal line for connecting the EMS 200 and CT sensor 110A and the signal line for connecting the EMS 200 and the smart meter 300 may be wireless or wired.

The smart meter 300 measures the power supplied to the consumer's facility 10 from the power grid 400 and the power reversely flown from the consumer's facility 10. For example, the smart meter 300 is connected to a power line at a location closer to a power grid 400 than the distribution board 110, and measures the amount of power flowing through the power line. Here, it should be noted that the smart meter 300 is equipment for calculating the charging for the power supplied to the consumer's facility 10 from the power grid 400 and an incentive for the reversely flown power.

In the first embodiment, the smart meter 300 transmits, to the EMS 200, an accumulated value that is a value obtained by aggregating the power supplied to the consumer's facility 10 from the power grid 400 within respective certain period (for example, 30 minutes). The smart meter 300 may transmit, together with the accumulated value, an aggregation time indicating a time at which the accumulated value is aggregated, to the EMS 200.

### (Smart meter)

The smart meter according to the first embodiment will be described, below.

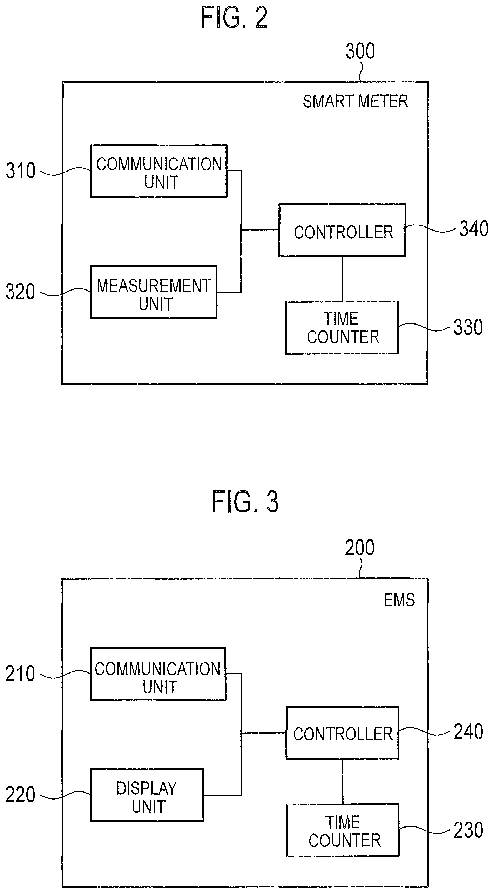

As illustrated in Fig. 2, the smart meter 300 includes a communication unit 310, a measurement unit 320, a time counter 330, and a controller 340.

The communication unit 310 is configured by a communication module and performs communication with the EMS 200. Specifically, the communication unit 310 transmits the accumulated value described above to the EMS 200. The communication unit 310 may transmit, together with the above-described accumulated value, the aggregation time to the EMS 200.

The measurement unit 320 measures the power supplied to the consumer's facility 10 from the power grid 400. The time counter 330 is configured by a clock oscillator or the like and counts the time by counting up or down. It should be noted that the aforementioned aggregation time is a time specified with reference to a time counted by the smart meter 300 (time counter 330).

The controller 340 is configured by a CPU (Central Processing Unit) and a memory, and controls the smart meter 300. Specifically, the controller 340 totals the power measured by the measurement unit 320 within respective certain period (for example, 30 minutes). The controller 340 instructs, if the accumulated value is aggregated, the communication unit 310 to transmit the accumulated value. The controller 340 may instruct the communication unit 310 to transmit the accumulated value and the aggregation time.

### (Power management apparatus)

The power management apparatus according to the first embodiment will be described, below.

As illustrated in Fig. 3, the EMS 200 includes a communication unit 210, a display unit 220, a time counter 230, and a controller 240.

The communication unit 210 is configured by a communication module and performs communication with an equipment connected via a signal line. Likewise, the communication unit 210 performs communication with the CT sensor 110A and the smart meter 300, both of which are connected via a signal line.

In the first embodiment, the communication unit 210 receives the accumulated value from the smart meter 300 at first intervals (for example, every 30 minutes), the accumulated value being a value obtained by aggregating the power supplied to the consumer's facility 10 from the power grid 400 within respective certain period (for example, 30 minutes). The communication unit 210 receives, from the CT sensor 110A, the measured value of the power supplied from the power grid 400 to the consumer's facility 10 during a time since an n^{th} (n is an integer of 0 or more) accumulated value is confirmed until an n+1^{th} accumulated value is confirmed. The communication unit 210 is set to periodically receive the measured value at an interval shorter than the first interval (for example, 30 minutes), for example. The interval receiving the measured value from the CT sensor 110A may be a fixed interval or may be a different interval.

The display unit 220 is configured by a display, and displays various information. Specifically, the display unit 220 configures a display unit that displays confirmed information indicating the accumulated value received at the first interval. The display unit 220 displays complementary information which complements the accumulated value on the basis of the measured value, during a time since the n^{th} accumulated value is confirmed until the n+1^{th} accumulated value is confirmed.

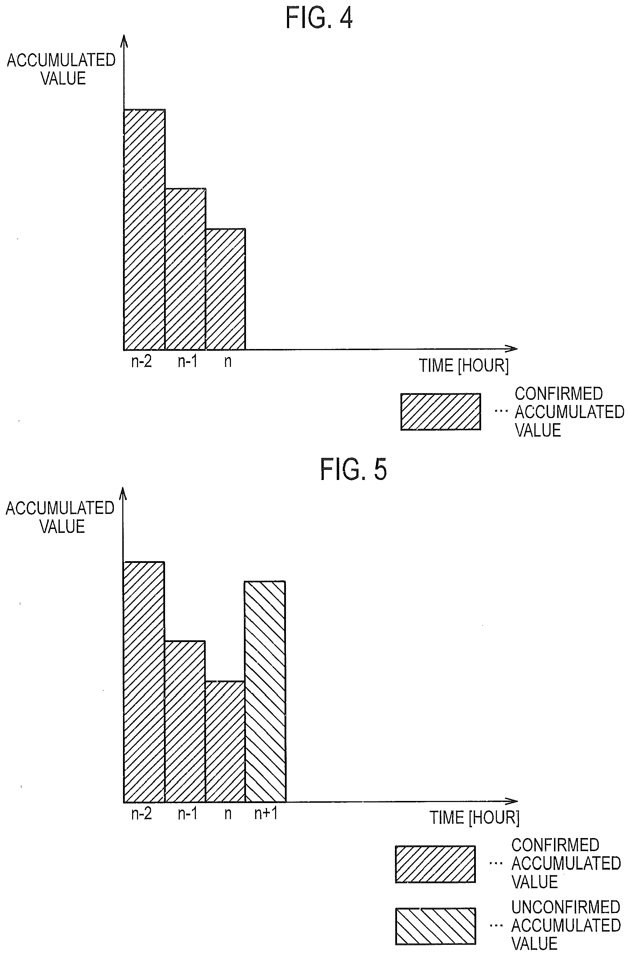

For example, a case is considered where the n^{th} accumulated value is confirmed and the n+1^{th} accumulated value is not confirmed. In such a case, the display unit 220 displays, as the confirmed information, the accumulated value received from the smart meter 300 (i.e., the confirmed accumulated value), as illustrated in Fig. 4. It is noted that Figs. 4 and 5 illustrate a case where n is 3 or more.

Further, the display unit 220 displays, as the complementary information, the accumulated value calculated on the basis of the measured value (i.e., an unconfirmed accumulated value) received from the CT sensor 110A, as illustrated in Fig. 5. It should be noted that the unconfirmed accumulated value is calculated by accumulation of an interval receiving the measured value and the measured value. The unconfirmed accumulated value may be displayed to increase along with each reception of the measured value (if a bar graph is concerned, to be stacked). Further, the measured value may be changed in mode (for example, color) depending on a time zone to which the reception period belongs.

Here, in Fig. 4 and Fig. 5, the accumulated value provided by the display unit 220 may be in a unit of 30 minutes and may be a unit of one hour. Here, for convenience of explanation, a case where the accumulated value is displayed in a unit of 30 minutes is provided as an example.

The time counter 230 is configured by a clock oscillator or the like and counts the time by counting up or down.

The controller 240 is configured by a CPU and a memory, and controls the EMS 200. Specifically, the controller 240 manages the accumulated value received from the smart meter 300. Further, the controller 240 calculates the unconfirmed accumulated value on the basis of the measured value received from the CT sensor 110A.

### (Management method)

A management method according to the first embodiment will be described, below.

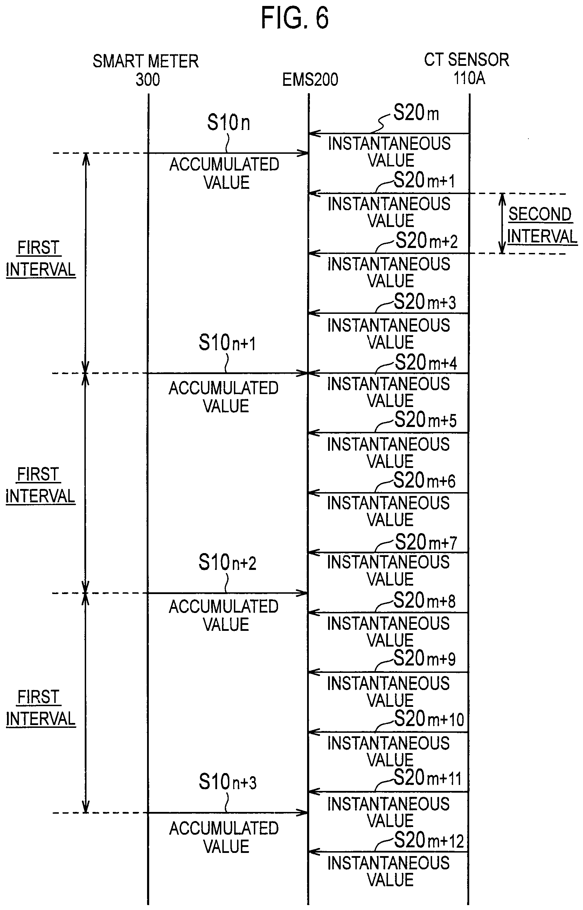

As illustrated in Fig. 6, in step S10, the EMS 200 receives the accumulated value from the smart meter 300 at the first interval, the accumulated value being the value obtained by aggregating the power supplied to the consumer's facility 10 from the power grid 400 within respective certain period (for example, 30 minutes). Step S10 is repeated at the respective certain period. A suffix (subscript) of a step number denotes the number of times in which the accumulated value is received.

In step S20, the EMS 200 receives the measured value from the CT sensor 110A, the measured value being the value of the power supplied to the consumer's facility 10 from the power grid 400. Step S20 is repeated at the second interval. A suffix (subscript) of a step number denotes the number of times in which the accumulated value is received.

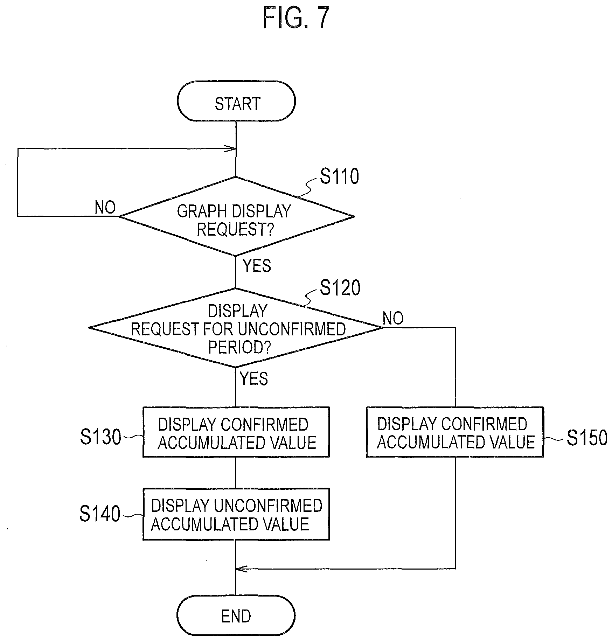

Under such a precondition, as illustrated in Fig. 7, in step S110, the EMS 200 determines whether or not to have received a graph display request by a user operation. If a determination result is YES, the EMS 200 moves to a process of step S120. On the other hand, if the determination result is NO, the EMS 200 keeps a state of waiting for a user operation.

In step S120, the EMS 200 determines by a user operation whether or not to have received a display request for the unconfirmed period. If a determination result is YES, the EMS 200 moves to a process of step S130. On the other hand, if the determination result is NO, the EMS 200 moves to a process of step S150.

In step S130, the EMS 200 displays, as the confirmed information, the accumulated value received from the smart meter 300 (i.e., the confirmed accumulated value) (see Fig. 4).

In step S140, as the complementary information, the EMS 200 displays, in addition to the confirmed accumulated value displayed in step S130, the accumulated value (i.e., unconfirmed accumulated value) calculated on the basis of the measured value received from the CT sensor 110A (see Fig. 5).

Here, for convenience of explanation, in the above description, step S130 and step S140 are separate processes; however, step S130 and step S140 may be performed simultaneously.

In step S150, the EMS 200 displays, as the confirmed information, the accumulated value received from the smart meter 300 (i.e., the confirmed accumulated value) (see Fig. 4).

As described above, in the first embodiment, the EMS 200 (the display unit 220) displays, during a time since the n^{th} accumulated value is confirmed until the n+1^{th} accumulated value is confirmed, the complementary information which complements the accumulated value on the basis of the measured value received from the CT sensor 110A provided separately from the smart meter 300. Thus, even without requiring the transmission of the instantaneous value to the smart meter 300, it is possible to complement the accumulated value confirmed at every certain period.

Incidentally, since the accumulated value is not updated unless a certain period elapses, it is not possible to grasp the variation of the accumulated value within respective certain period. On the other hand, it is assumed that, depending on the specifications of the smart meter, when frequently receiving a transmission request for the instantaneous value, the smart meter may determine that the transmission request for the instantaneous value is an illegal signal (for example, DOS attack). Therefore, in order to increase the accuracy of complementing the accumulated value, it is not preferable to frequently request the smart meter to transmit the instantaneous value; however, if the CT sensor is used to complement the value, as described above, it is possible to improve the convenience of a consumer.

### [First Modification]

A first modification of the first embodiment will be described, below. Description proceeds with a focus on a difference from the first embodiment, below.

Although not particularly mentioned in the first embodiment, in the first modification, the EMS 200 (controller 240) corrects, on the basis of the accumulated value received from the smart meter 300, the complementary information displayed on the basis of the measured value received from the CT sensor 110A. For example, if receiving the n+1^{th} accumulated value, the EMS 200 (controller 240) corrects, on the basis of the n+1^{th} accumulated value (confirmed accumulated value), the complementary information displayed on the basis of the measured value received from the CT sensor 110A, during a time since the n^{th} accumulated value is confirmed until the n+1^{th} accumulated value is confirmed.

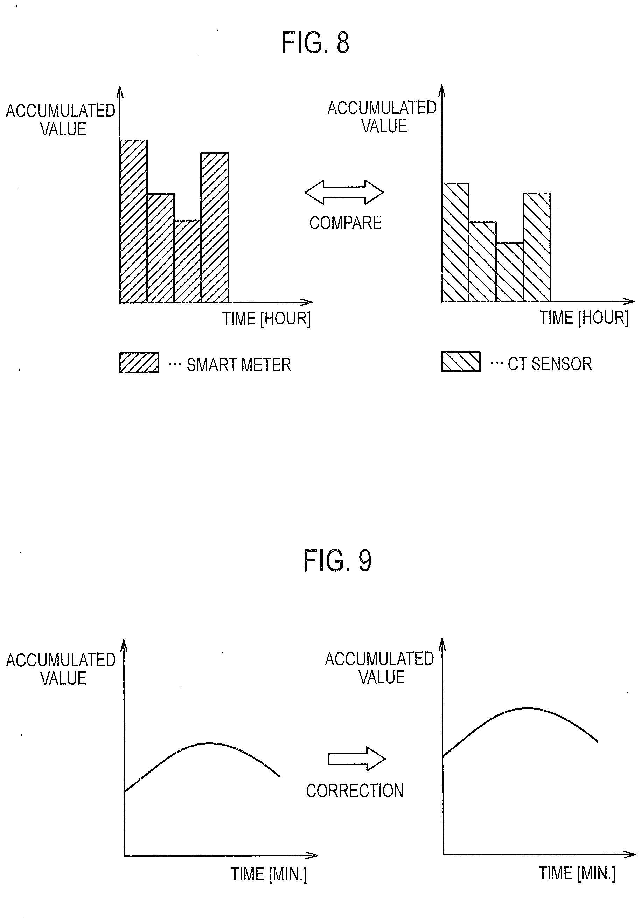

Specifically, as illustrated in Fig. 8, the EMS 200 compares the accumulated value calculated on the basis of the measured value received from the CT sensor 110A, with the accumulated value received from the smart meter 300. It should be noted that the accumulated value received at the first interval from the smart meter 300 is a result of aggregating the power in a certain period (for example, 30 minutes), and thus, the accumulated value calculated on the basis of the measured value received from the CT sensor 110A is also an estimated value in a certain period (for example, 30 minutes).

The EMS 200 calculates, on the basis of such a comparison result, a correction coefficient of the measured value received from the CT sensor 110A. For example, as illustrated in Fig. 8, if the accumulated value received from the smart meter 300 is greater than the accumulated value calculated on the basis of the measured value received from the CT sensor 110A, the correction coefficient larger is a value greater than 1.

The EMS 200 multiplies the measured value received from the CT sensor 110A by the correction coefficient to thereby correct the measured value received from the CT sensor 110A, as illustrated in Fig. 9.

Thus, even if the accumulated value is complemented on the basis of the measured value received from the CT sensor 110A provided separately from the smart meter 300 that performs charging for the power supplied to the consumer's facility 10 from the power grid 400, it is possible to display the complementary information appropriate as the information indicating a billing status.

### [Second Modification]

A second modification of the first embodiment is described, below. Description proceeds with a focus on a difference from the first embodiment, below.

Although not particularly mentioned in the embodiment, in the second modification, the EMS 200 (display unit 220) displays the complementary information on the basis of the measured value, in a certain period during which the accumulated value from the smart meter 300 was missed at the first interval.

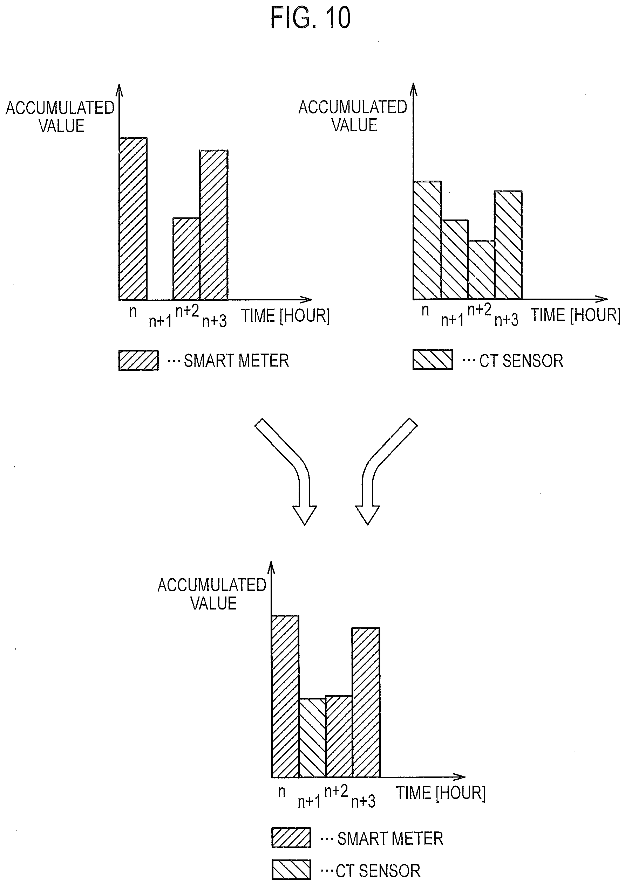

Specifically, as illustrated in Fig. 10, the EMS 200 (controller 240) manages, in addition to managing the accumulated value received from the smart meter 300, the accumulated value calculated on the basis of the measured value received from the CT sensor 110A. Here, a case is assumed where out of the accumulated values received from the smart meter 300, the n+1^{th} accumulated value is missing.

In such a case, as illustrated in Fig. 10, for the n+1^{th} period, the EMS 200 (display unit 220) displays, as the complementary information, the accumulated value calculated on the basis of the measured value received from the CT sensor 110A.

In the embodiment, the EMS 200 receives a forward power flow curtail message (for example, DR: Demand Response) requesting curtail of a forward power flow amount (supplied power amount) from the power grid to the consumer's facility 10. In addition, the EMS 200 transmits a reverse power flow curtail message requesting curtail of a reverse power flow amount from the consumer's facility 10 to the power grid. In the embodiment, the forward power flow curtail message and the reverse power flow curtail message are collectively referred to as power instruction message.

Here, the forward power flow curtail message includes information indicating a degree of curtail of the amount of power (forward power flow amount) supplied to the consumer's facility 10 from the power grid. The reverse power flow curtail message includes information indicating a degree of curtail of the amount of power (reverse power flow amount) output from the consumer's facility 10 to the power grid.

The curtail degree may be represented by an absolute value of the power amount (for example, xx kW). Alternatively, the curtail degree may be represented by a relative value of the power amount (for example, decrease by xx kW). Alternatively, the curtail degree may be represented by a curtail ratio of the power amount (for example, xx%). Alternatively, the forward power flow curtail message may include information indicating a power purchase price that is a consideration for the power flown from the power grid.

It is noted that the curtail ratio of the reverse power flow curtail may be a ratio of the reverse flow curtail amount relative to output certified, when a distributed power source is installed in the consumer's facility 10, as the output capability of a PCS that controls the distributed power source (hereinafter, facility certified output). If the output capability of the distributed power source and that of the PCS differ, as the facility certified output, a smaller output capability is selected out of the output capabilities. In a case where a plurality of PCSs are installed, the facility certified output is a sum of the output capabilities of the plurality of PCSs.

Here, as a format of the forward power flow curtail message and the reverse power flow curtail message, it is possible to use a format that complies with an automated demand response (ADR). As a scheme that complies with this standard, for example, a scheme that complies with an Open ADR standard may be used.

After the EMS 200 receives the power instruction message, before and after a time at which the power instruction message is started, the interval receiving the measured value from the CT sensor 110A may be changed. More specifically, before a predetermined time at which a content of the power instruction message is started (for example, 10 minutes), the interval receiving the measured value from the CT sensor 110A may be shortened. For example, usually, if the measured value has been cyclically received from the CT sensor 110A at a first interval, the measured value may be received at a second interval (for example, at intervals of one minute) shorter than the first interval before a predetermined time at which the power instruction message is started.

Thus, when the interval of the measured value is further shortened before and after the power instruction message is started, it is possible to more accurately grasp the power situation of the consumer's facility, thereby improving the convenience of the consumer.

Also, depending on the degree of curtail of the power instruction message, the interval receiving the measured value within an execution period of the power instruction message may be changed. More specifically, if the power instruction message is a demand response, when the unconfirmed accumulated value calculated on the basis of the measured value is approaching a threshold value set according to the amount of curtail, the measured value may be received at a shorter interval.

### [Third Modification]

A third modification of the first embodiment will be described, below. Description proceeds with a focus on a difference from the first embodiment or the second embodiment, below.

In the embodiment, the distributed power source such as the PV unit 130 is connected via the smart meter 300 to the power grid 400. "Via the smart meter 300" may mean being serially connected and may also mean being connected in parallel, as illustrated in Fig. 1. In order to measure input/output power of such a distributed power source, a second CT sensor (second power sensor), separately from the CT sensor 110A, is installed at a location closer to the distributed power source than the CT sensor 110A. More specifically, in order to measure the input/output power of the distributed power source branching from a power line, the second CT sensor is installed between a branch point and the distributed power source.

In the EMS 200, the communication unit 310 receives a second measured value from the second CT sensor at a second interval. The second measured value is a value indicating the input/output power of the distributed power source. The second interval receiving the second measured value may be set appropriately, and may be set to the same interval as the interval of the measured value received from the CT sensor 110A, for example. It is noted that the second interval receiving the second measured value may be set shorter than the interval receiving the measured value and may be set longer than the interval receiving the measured value.

The EMS 200 may display, on the basis of the second measured value, a breakdown of the complementary information on the display unit 220. When the content of the complementary information is displayed, it is possible to grasp the power situation in more detail and it is thus possible to improve the convenience of the consumer. It is noted that the second measured value may be corrected in accordance with the correction on the measured value.

### [Other Embodiments]

The present invention is explained through the above-described embodiment, but it must not be assumed that this invention is limited by the statements and the drawings constituting a part of this disclosure. From this disclosure, various alternative embodiments, examples, and operational technologies will become apparent to those skilled in the art.

In the embodiment, the CT sensor 110A is arranged in the distribution board 110. However, the embodiment is not limited thereto. It may suffice that the CT sensor 110A is arranged at a position capable of measuring the power supplied to the consumer's facility 10 from the power grid 400.

Although not particularly mentioned in the embodiment, the EMS 200 (display unit 220) may display the complementary information in a manner different from that to display the confirmed information. For example, the color for displaying the complementary information may be different from the color for displaying the confirmed information. Alternatively, a display manner for the complementary information may be blinking and a display manner for the confirmed information may be lighting.

Although not particularly mentioned in the embodiment, the communication between the EMS 200 and the CT sensor 110A and the communication between the EMS 200 and the smart meter 300 preferably comply with ECHONET Lite scheme. However, the communication between the EMS 200 and CT sensor 110A and the communication between EMS 200 and the smart meter 300 may comply with another communications protocol.

Although not particularly mentioned in the embodiment, the EMS 200 may be a home server arranged in the consumer's facility 10. Alternatively, the EMS 200 may be a user terminal represented by a smart phone.

In the embodiment, a case where the power management apparatus is the EMS 200 is provided as an example. However, the embodiment is not limited thereto. The power management apparatus may be arranged in BEMS (Building Energy Management System), may be provided in FEMS (Factory Energy Management System), and may be provided in SEMS (Store Energy Management System).

### INDUSTRIAL APPLICABILITY

The present invention is useful for techniques for managing power.

## Claims

1. A power management apparatus (200) comprising:
a first receiver (210) configured to receive an accumulated value from a smart meter (300) at a first interval, the smart meter (300) being configured to measure an amount of power flow between a power grid and a facility, the accumulated value being a value obtained by aggregating the amount of power flow within a certain period between the power grid and the facility;
a second receiver (210) configured to receive a measured value from a power sensor (110A) at an interval shorter than the first interval, the measured value being a value of a power supplied from the power grid to the facility, the power sensor (110A) provided separately from the smart meter (300);
a controller (240) configured to calculate, on the basis of the measured value, complementary information which complements the accumulated value;
the power management apparatus **characterised by** comprising a third receiver (210) configured to receive a power instruction message requesting a curtailment of a forward power flow amount from the power grid to the facility or a reverse power flow amount from the facility to the power grid; and
the second receiver (210) being further configured to, after the power instruction message is received by the third receiver (210), shorten the interval for receiving the measured value at a predetermined time before the power instruction message is started.

2. The power management apparatus (200) according to claim 1, comprising:
a display unit (220) configured to display confirmed information indicating the accumulated value received at the first interval and the complementary information.

3. The power management apparatus (200) according to claim 2,
the display unit (220) being further configured to display the confirmed information and the complementary information in a different manner.

4. The power management apparatus (200) according to any one of claims 1 to 3,
the second receiver (210) being configured to receive the measured value from the power sensor (110A) during a time since an n^{th} accumulated value is confirmed until an n+1^{th} accumulated value is confirmed, wherein n is an integer equal or greater than 0.

5. The power management apparatus (200) according to claim 4, the display unit (220) being configured to display the complementary information on the basis of the measured value, during a time since the n^{th} accumulated value is confirmed until the n+1^{th} accumulated value is confirmed.

6. The power management apparatus (200) according to any one of claims 1 to 4, the second receiver (210) being further configured to periodically receive the measured value.

7. The power management apparatus (200) according to claim 4, comprising:
a correction unit being configured to correct the complementary information on the basis of the accumulated value, when the first receiver (210) receives the n+1^{th} accumulated value.

8. The power management apparatus (200) according to claim 2,
the display unit (220) being further configured to display the complementary information on the basis of the measured value in a certain period during which acquisition of the accumulated value fails.

9. The power management apparatus (200) according to any one of claims 1 to 8 comprising:
a distributed power source configured to be connected via the smart meter (300) to the power grid;
a second power sensor (110A) installed at a location closer to the distributed power source than the power sensor (110A); and
a fourth receiver being configured to receive a second measured value from the second power sensor (110A) at a second interval.

10. The power management apparatus (200) according to claim 9, wherein
the fourth receiver is configured to receive the second measured value at the same interval as the interval at which the second receiver (210) receives the measured value.

11. A power management method comprising the steps of:
receiving an accumulated value from a smart meter (300) at a first interval, the smart meter (300) measuring an amount of power flow between a power grid and a facility, the accumulated value being a value obtained by aggregating the amount of power flow within a certain period between the power grid and the facility;
receiving a measured value from a power sensor (110A) at an interval shorter than the first interval, the measured value being a value of a power supplied from the power grid to the facility, the power sensor (110A) provided separately from the smart meter (300);
receiving a power instruction message requesting a curtailment of a forward power flow amount from the power grid to the facility or a reverse power flow amount from the facility to the power grid;
calculating, on the basis of the measured value, complementary information which complements the accumulated value; and
after receiving the power instruction message, shortening the interval for receiving the measured value at a predetermined time before the power instruction message is started.

12. A power management system comprising:
a power management apparatus (200) according to any one of claims 1 to 10; and
the power sensor (110A).

## Patentansprüche

1. Leistungsmanagementvorrichtung (200), die Folgendes umfasst:
einen ersten Empfänger (210), der konfiguriert ist, einen akkumulierten Wert von einem intelligenten Zähler (300) in einem ersten Intervall zu empfangen, wobei der intelligente Zähler (300) konfiguriert ist, einen Betrag eines Leistungsflusses zwischen einem Stromnetz und einer Anlage zu messen, und der akkumulierte Wert ein Wert ist, der durch Akkumulieren des Betrags des Leistungsflusses in einem bestimmen Zeitraum zwischen dem Stromnetz und der Anlage erhalten wird;
einen zweiten Empfänger (210), der konfiguriert ist, einen Messwert von einem Leistungssensor (110A) in einem Intervall, das kürzer als das erste Intervall ist, zu empfangen, wobei der Messwert ein Wert einer Leistung, die vom Stromnetz zur Anlage geliefert wird, ist und der Leistungssensor (110A) getrennt vom intelligenten Zähler (300) vorgesehen ist; und
eine Steuereinheit (240), die konfiguriert ist, auf der Grundlage des Messwerts ergänzende Informationen zu berechnen, die den akkumulierten Wert ergänzen; wobei
die Leistungsmanagementvorrichtung **gekennzeichnet ist durch**
einen dritten Empfänger (210), der konfiguriert ist, eine Leistungsanweisungsnachricht zu empfangen, die eine Kürzung eines Vorwärtsleistungsflussbetrags vom Stromnetz zur Anlage oder eines Rückwärtsleistungsflussbetrags von der Anlage zum Stromnetz anfordert; wobei
der zweite Empfänger (210) ferner konfiguriert ist, nachdem die Leistungsanweisungsnachricht durch den dritten Empfänger (210) empfangen worden ist, das Intervall zum Empfangen des Messwerts zu einer vorgegebenen Zeit zu verkürzen, bevor die Leistungsanweisungsnachricht gestartet wird.

2. Leistungsmanagementvorrichtung (200) nach Anspruch 1, die Folgendes umfasst:
eine Anzeigeeinheit (220), die konfiguriert ist, bestätigte Informationen anzuzeigen, die den akkumulierten Wert, der im ersten Intervall empfangen wurde, und die ergänzenden Informationen angeben.

3. Leistungsmanagementvorrichtung (200) nach Anspruch 2, wobei
die Anzeigeeinheit (220) ferner konfiguriert ist, die bestätigten Informationen und die ergänzenden Informationen auf verschiedene Weise anzuzeigen.

4. Leistungsmanagementvorrichtung (200) nach einem der Ansprüche 1 bis 3, wobei
der zweite Empfänger (210) konfiguriert ist, den Messwert vom Leistungssensor (110A) während einer Zeit von der Bestätigung eines n-ten akkumulierten Wertes bis zur Bestätigung eines n + 1-ten akkumulierten Wertes zu empfangen, wobei n eine ganze Zahl gleich oder größer als 0 ist.

5. Leistungsmanagementvorrichtung (200) nach Anspruch 4, wobei
die Anzeigeeinheit (220) konfiguriert ist, die ergänzenden Informationen auf der Grundlage des Messwerts während einer Zeit von der Bestätigung eines n-ten akkumulierten Wertes bis zur Bestätigung eines n + 1-ten akkumulierten Wertes anzuzeigen.

6. Leistungsmanagementvorrichtung (200) nach einem der Ansprüche 1 bis 4, wobei
der zweite Empfänger (210) ferner konfiguriert ist, den Messwert regelmäßig zu empfangen.

7. Leistungsmanagementvorrichtung (200) nach Anspruch 4, die Folgendes umfasst:
eine Korrektureinheit, die konfiguriert ist, die ergänzenden Informationen auf der Grundlage des akkumulierten Werts zu korrigieren, wenn der erste Empfänger (210) den n + 1-ten akkumulierten Wert empfängt.

8. Leistungsmanagementvorrichtung (200) nach Anspruch 2, wobei
die Anzeigeeinheit (220) ferner konfiguriert ist, die ergänzenden Informationen auf der Grundlage des Messwerts in einem bestimmten Zeitraum, während dessen eine Erfassung des akkumulierten Werts fehlschlägt, anzuzeigen.

9. Leistungsmanagementvorrichtung (200) nach einem der Ansprüche 1 bis 8, die Folgendes umfasst:
eine verteilte Leistungsquelle, die konfiguriert ist, mittels des intelligenten Zählers (300) mit dem Stromnetz verbunden zu werden;
einen zweiten Leistungssensor (110A), der an einem Ort, der näher bei der verteilten Leistungsquelle liegt als der Leistungssensor (110A), installiert ist; und
einen vierten Empfänger, der konfiguriert ist, einen zweiten Messwert vom zweiten Leistungssensor (110A) in einem zweiten Intervall zu empfangen.

10. Leistungsmanagementvorrichtung (200) nach Anspruch 9, wobei
der vierte Empfänger konfiguriert ist, den zweiten Messwert im selben Intervall wie das Intervall, in dem der zweite Empfänger (210) den Messwert empfängt, zu empfangen.

11. Leistungsmanagementverfahren, das die folgenden Schritte umfasst:
Empfangen eines akkumulierten Werts von einem intelligenten Zähler (300) in einem ersten Intervall, wobei der intelligente Zähler (300) einen Betrag eines Leistungsflusses zwischen einem Stromnetz und einer Anlage misst und der akkumulierte Wert ein Wert ist, der durch Akkumulieren des Betrags des Leistungsflusses in einem bestimmen Zeitraum zwischen dem Stromnetz und der Anlage erhalten wird;
Empfangen eines Messwerts von einem Leistungssensor (110A) in einem Intervall, das kürzer als das erste Intervall ist, wobei der Messwert ein Wert einer Leistung, die vom Stromnetz zur Anlage geliefert wird, ist und der Leistungssensor (110A) getrennt vom intelligenten Zähler (300) vorgesehen ist;
Empfangen einer Leistungsanweisungsnachricht, die eine Kürzung eines Vorwärtsleistungsflussbetrags vom Stromnetz zur Anlage oder eines Rückwärtsleistungsflussbetrags von der Anlage zum Stromnetz anfordert;
Berechnen auf der Grundlage des Messwerts ergänzender Informationen, die den akkumulierten Wert ergänzen; und
Verkürzen nach dem Empfangen der Leistungsanweisungsnachricht des Intervalls zum Empfangen des Messwerts zu einer vorgegebenen Zeit, bevor die Leistungsanweisungsnachricht gestartet wird.

12. Leistungsmanagementsystem, das Folgendes umfasst:
eine Leistungsmanagementvorrichtung (200) nach einem der Ansprüche 1 bis 10; und
den Leistungssensor (110A).

## Revendications

1. Appareil de gestion de puissance (200) comprenant :
un premier récepteur (210) configuré pour recevoir une valeur cumulée d'un compteur intelligent (300) à un premier intervalle, le compteur intelligent (300) étant configuré pour mesurer une quantité de flux de puissance entre un réseau électrique et une installation, la valeur cumulée étant une valeur obtenue en agrégeant la quantité de flux de puissance pendant une certaine période entre le réseau électrique et l'installation ;
un second récepteur (210) configuré pour recevoir une valeur mesurée d'un capteur de puissance (110A) à un intervalle plus court que le premier intervalle, la valeur mesurée étant une valeur d'une puissance fournie par le réseau électrique à l'installation, le capteur de puissance (110A) étant fourni séparément du compteur intelligent (300) ;
une commande (240) configurée pour calculer, sur la base de la valeur mesurée, des informations complémentaires qui complètent la valeur cumulée ;
l'appareil de gestion de puissance étant **caractérisé en ce qu'**il comprend
un troisième récepteur (210) configuré pour recevoir un message d'instruction de puissance demandant une réduction d'une quantité de flux de puissance aller du réseau électrique vers l'installation ou d'une quantité de flux de puissance retour de l'installation vers le réseau électrique ; et
le deuxième récepteur (210) étant en outre configuré pour, après la réception du message d'instruction de puissance par le troisième récepteur (210), raccourcir l'intervalle de réception de la valeur mesurée à un moment prédéterminé avant le démarrage du message d'instruction de puissance.

2. Appareil de gestion de puissance (200) selon la revendication 1, comprenant :
une unité d'affichage (220) configurée pour afficher des informations confirmées indiquant la valeur cumulée reçue au premier intervalle et les informations complémentaires.

3. Appareil de gestion de l'énergie (200) selon la revendication 2,
l'unité d'affichage (220) étant en outre configurée pour afficher les informations confirmées et les informations complémentaires d'une manière différente.

4. Appareil de gestion de puissance (200) selon l'une quelconque des revendications 1 à 3,
le second récepteur (210) étant configuré pour recevoir la valeur mesurée du capteur de puissance (110A) pendant une période allant de la confirmation d'une n^{ième} valeur cumulée jusqu'à la confirmation d'une n+1^{ième} valeur cumulée, où n est un entier égal ou supérieur à 0.

5. Appareil de gestion de puissance (200) selon la revendication 4,
l'unité d'affichage (220) étant configurée pour afficher les informations complémentaires sur la base de la valeur mesurée, pendant une période allant de la confirmation de la n^{ième} valeur cumulée jusqu'à la confirmation de la n+1^{ième} valeur cumulée.

6. Appareil de gestion de puissance (200) selon l'une quelconque des revendications 1 à 4,
le deuxième récepteur (210) étant en outre configuré pour recevoir périodiquement la valeur mesurée.

7. Appareil de gestion de puissance (200) selon la revendication 4, comprenant :
une unité de correction étant configurée pour corriger les informations complémentaires sur la base de la valeur cumulée, lorsque le premier récepteur (210) reçoit la n+lème valeur cumulée.

8. Appareil de gestion de puissance (200) selon la revendication 2,
l'unité d'affichage (220) étant en outre configurée pour afficher les informations complémentaires sur la base de la valeur mesurée dans une certaine période pendant laquelle l'acquisition de la valeur cumulée échoue.

9. Appareil de gestion de puissance (200) selon l'une quelconque des revendications 1 à 8 comprenant :
une source d'énergie distribuée configurée pour être connectée au réseau électrique via le compteur intelligent (300) ;
un second capteur de puissance (110A) installé en un endroit plus proche de la source d'énergie distribuée que le capteur de puissance (110A) ; et
un quatrième récepteur étant configuré pour recevoir une seconde valeur mesurée du second capteur de puissance (110A) à un second intervalle.

10. Appareil de gestion de puissance (200) selon la revendication 9, où
le quatrième récepteur est configuré pour recevoir la deuxième valeur mesurée au même intervalle que celui auquel le deuxième récepteur (210) reçoit la valeur mesurée.

11. Procédé de gestion de puissance (200) comprenant :
la réception d'une valeur cumulée en provenance d'un compteur intelligent (300) à un premier intervalle, le compteur intelligent (300) mesurant une quantité de flux de puissance entre un réseau électrique et une installation, la valeur cumulée étant une valeur obtenue en agrégeant la quantité de flux de puissance pendant une certaine période entre le réseau électrique et l'installation ;
la réception d'une valeur mesurée en provenance d'un capteur de puissance (110A) à un intervalle plus court que le premier intervalle, la valeur mesurée étant une valeur d'une puissance fournie par le réseau électrique à l'installation, le capteur de puissance (110A) étant fourni séparément du compteur intelligent (300) ;
la réception d'un message d'instruction de puissance demandant une réduction d'une quantité de flux de puissance aller du réseau électrique vers l'installation ou d'une quantité de flux de puissance retour de l'installation vers le réseau électrique ;
le calcul, sur la base de la valeur mesurée, d'informations complémentaires qui complètent la valeur cumulée ; et
après la réception du message d'instruction de puissance, le raccourcissement de l'intervalle de réception de la valeur mesurée à un moment prédéterminé avant le démarrage du message d'instruction de puissance.

12. Système de gestion de puissance comportant :
un appareil de gestion de puissance (200) selon l'une quelconque des revendications 1 à 10, et
le capteur de puissance (110A).
